# EUROPÄISCHE PATENTANMELDUNG

(11) **EP 4 395 514 A1**
(43) Veröffentlichungstag der Anmeldung: **03.07.2024**
(21) Anmeldenummer: 22217435.1
(22) Anmeldetag: 31.12.2022
(51) Int. Cl.: H10K 77/10, H10K 30/50, H10K 71/13

(54) **VERFAHREN ZUM AUFBRINGEN EINER BESCHICHTUNG AUF EIN FAHRZEUG ODER EIN FAHRZEUGTEIL**

(71) Anmelder: Fredy Doll Beteiligungs-GmbH, 77855 Achern (DE); Winkelmann, Ralf, 54411 Hermeskeil (DE)
(72) Erfinder: Winkelmann, Ralf, 54411 Hermeskeil (DE); Doll, Fredy, 77855 Achern (DE)
(74) Vertreter: LBP Lemcke, Brommer & Partner Patentanwälte mbB

(57) **Zusammenfassung**

Die Erfindung betrifft ein Verfahren zum Aufbringen einer Beschichtung auf ein Fahrzeug, insbesondere ein Automobil, oder ein Fahrzeugteil (1), mit den Verfahrensschritten:
A) Bereitstellen eines Fahrzeugs oder Fahrzeugteils (1);
B) Aufbringen eines flüssigen Beschichtungsmaterials (2) auf eine Oberfläche (11) des Fahrzeuges oder des Fahrzeugteils (1) mittels eines Applikators, wobei das Beschichtungsmaterial (2) in einzelnen Punkten (3) auf die Oberfläche (11) aufgebracht wird, wobei die Punkte (3) aneinandergrenzend oder überlappend zueinander auf der Oberfläche (11) angeordnet werden, so dass diese eine zusammenhängende Linie (4) oder Fläche (5) ausbilden.

Das erfindungsgemäße Verfahren zeichnet sich dadurch aus, dass als Beschichtungsmaterial (2) zumindest ein halbleitendes Material verwendet wird.

## Beschreibung

Die Erfindung betrifft ein Verfahren zum Aufbringen einer Beschichtung auf ein Fahrzeug, insbesondere ein Automobil, oder ein Fahrzeugteil, wobei das Verfahren den Verfahrensschritt A) Bereitstellen eines Fahrzeugs oder Fahrzeugteils und den Verfahrensschritt B) Aufbringen eines flüssigen Beschichtungsmaterials auf eine Oberfläche des Fahrzeuges oder des Fahrzeugteils mittels eines Applikators umfasst, wobei das Beschichtungsmaterial in einzelnen Punkten auf die Oberfläche aufgebracht wird, und wobei die Punkte aneinandergrenzend oder überlappend zueinander auf der Oberfläche angeordnet werden, so dass diese eine zusammenhängende Linie oder Fläche ausbilden.

Die Beschichtung von Fahrzeugen ist im Stand der Technik bekannt. Hierzu gibt es verschiedene Verfahren zur Beschichtung zu Fahrzeugteilen, insbesondere zur Auftragung eines Lacks oder einer Folie auf ein Fahrzeugteil. Mit der Beschichtung soll insbesondere die Außenhaut des Fahrzeugs vor Umwelteinflüssen geschützt werden.

Weiterhin sind auch solaraktive Bauteile zur Gewinnung von Wärme wie auch von elektrischer Energie aus Sonnenstrahlung allgemein bekannt. Die solaraktiven Bauteile zur Gewinnung von elektrischer Energie umfassen in der Regel Solarzellen aus einem Halbleitermaterial, wie beispielsweise kristallines oder amorphes Silizium, mittels welchen aus der auftreffenden Sonnenstrahlung elektrische Energie erzeugt wird. Zur Herstellung eines solaraktiven Bauteils, beispielsweise eines Solarmoduls, werden üblicherweise einzelne Solarzellen untereinander parallel oder seriell verschaltet und in ein Gehäuse eingebettet, wobei das Gehäuse auf der der Sonnenstrahlung zugewandten Seite meist eine Glasplatte zum Schutz der Solarzellen vor äußeren Einflüssen, wie beispielsweise Hagel, aufweist. Diese solaraktiven Bauteile besitzen jedoch oft ein hohes Gewicht und lassen sich oft nicht ohne weiteres in weitere Bauteile integrieren.

Insbesondere Fahrzeuge sowie dessen Fahrzeugteile bieten ein enormes Potential zur Gewinnung von elektrischer Energie aus Sonnenstrahlung. Mit der Elektromobilität bietet sich im unmittelbaren Umfeld von Fahrzeugen und Fahrzeugteilen eine direkte Anwendungsmöglichkeit zur Nutzung des erzeugten Stroms. Steht das Auto beispielsweise auf einem Parkplatz, kann während der Parkdauer mit der Beschichtung Strom erzeugt werden, welcher beispielsweise zum Laden der Batterie des Elektrofahrzeugs genutzt werden kann.

Im Bereich der Beschichtung von Fahrzeugteilen wird das flüssige Beschichtungsmaterial, beispielsweise in einer Kfz-Lackieranlage, üblicherweise in Form eines vernebelten Sprühstrahls auf die Oberflächen des Fahrzeuges oder Fahrzeugteils aufgebracht. Als problematisch bei der derartigen Aufbringung der Beschichtung hat sich der erforderliche Aufwand erwiesen, der unter anderem eine aufwändige Isolation des Beschichtungsbereichs sowie einen hohen Reinigungsaufwand der Anlagen aufgrund eines Tröpfchennebels aus dem Beschichtungsmaterial mit sich bringt. Auch ist der Verlust von flüssigem Beschichtungsmaterial, welches ungenutzt entweicht und nicht wieder rückgewonnen werden kann, beispielsweise weil es auf die das zu beschichtende Objekt Umgebung aufgetragen wurde, unter ökologischen und ökonomischen Gesichtspunkten nachteilig.

Es ist daher Aufgabe der Erfindung ein Verfahren zum Beschichten eines Fahrzeugs oder Fahrzeugteils anzugeben, mittels welchem die Beschichtung zur Erzeugung einer aktiven Fläche einfach, schnell und zuverlässig aufgebracht werden kann.

Diese und weitere Aufgaben werden gelöst durch ein Verfahren nach Anspruch 1. Vorteilhafte Ausgestaltungsformen des Verfahrens sind in den Ansprüchen 2 bis 15 dargelegt.

Gelöst wird die vorgenannte Aufgabe durch ein Verfahren zum Aufbringen einer Beschichtung auf ein Fahrzeug, insbesondere ein Automobil, oder ein Fahrzeugteil, mit den Verfahrensschritten:
A) Bereitstellen eines Fahrzeugs oder Fahrzeugteils;
B) Aufbringen eines flüssigen Beschichtungsmaterials auf eine Oberfläche des Fahrzeuges oder des Fahrzeugteils mittels eines Applikators. Das Beschichtungsmaterial wird hierbei in einzelnen Punkten auf die Oberfläche aufgebracht, wobei die Punkte aneinandergrenzend oder überlappend zueinander auf der Oberfläche angeordnet werden, so dass diese eine zusammenhängende Linie oder Fläche ausbilden.

Der Erfindung zeichnet sich dadurch aus, dass als Beschichtungsmaterial zumindest ein halbleitendes Material verwendet wird und/oder dass das Beschichtungsmaterial zumindest ein halbleitendes Material umfasst. Die Beschichtung mit einem halbleitenden Material hat viele Vorteile hinsichtlich elektronischer Anwendungen. Durch den Austrag des halbleitenden Material in einzelnen Punkten auf die Oberfläche können gezielt einzelne Bereiche und/oder das gesamte Fahrzeugteil mit dem halbleitenden Material beschichtet werden. Es ist auch eine gezielte und dosierte Austragung des halbleitenden Materials möglich, insbesondere mit einer gleichbleibenden Dicke, welche gerade für elektronische Anwendungen Relevanz haben kann.

Bei einem halbleitenden Material handelt es sich um ein chemisches Element oder eine chemische Verbindung oder eine Komponente einer Zusammensetzung, welche Eigenschaften eines Halbleiters aufweist. Insbesondere kann das halbleitende Material ein Halbleiter wie Silizium, Germanium oder Galliumnitrid sein, es kann sich aber auch um ein anderes Material wie ein Polymer handeln.

Das erfindungsgemäße Verfahren weist Ähnlichkeiten zur Funktionsweise eines Tintenstrahldruckers auf. Insbesondere wird kein undefinierter Sprühstrahl erzeugt, welcher sich teilweise auch unterschiedlich auf dem Fahrzeug oder Fahrzeugteil niederschlägt. Vielmehr wird stattdessen das flüssige Beschichtungsmaterial in Form einzelner Punkte bzw. Tropfen mit dem Applikator in einer bestimmten Richtung bzw. Form sequentiell und bedarfsweise ausgetragen. Zur Aufbringung der einzelnen Punkte bzw. Tropfen an Beschichtungsmaterial auf das Fahrzeug oder Fahrzeugteil wird der Applikator relativ zu dem Fahrzeug oder Fahrzeugteil bewegt und erzeugt somit eine Spur an Punkten mit Beschichtungsmaterial, wodurch eine zusammenhängende Linie oder Fläche ausgebildet wird.

Die Punkte der Linie können hierbei so angeordnet sein, dass diese eine gerade oder gekrümmte Anordnung aufweisen. Insbesondere kann die Linie jede beliebige Form aufweisen. Bevorzugt kann die Linie auch kreisbogenförmig, wellenförmig oder in einem Zick-Zack-Muster ausgebildet werden. Hierdurch kann die Linie der Kontur und/oder der Oberfläche des Fahrzeugs oder Fahrzeugteils angepasst werden. Benachbarte Linien können vorzugsweise so ausgebildet werden, dass diese versetzt zueinander angeordnet sind und ineinandergreifen. Besonders bevorzugt kann die Oberfläche des Fahrzeugs oder Fahrzeugteils durch die entsprechende Anordnung der Punkte und Wahl der Linienform optimal mit Beschichtungsmaterial beschichtet werden, insbesondere kann die Fläche mit Beschichtungsmaterial optimiert werden.

Die Punkte an Beschichtungsmaterial können durch Einstellung und/oder Anpassung der Austragsparameter, der Relativbewegung von Applikator und Fahrzeug oder Fahrzeugteil zielgenau auf die entsprechenden Flächen, insbesondere auch auf gekrümmte Flächen, aufgebracht werden. Insbesondere ist auch ein gezieltes Auftragen des Beschichtungsmaterials im Randbereich möglich, ohne dass in nennenswertem Umfang Beschichtungsmaterial an der jeweiligen Fläche vorbei ausgetragen wird und den Fertigungsbereich verschmutzt.

Vorzugsweise werden die Flächen aus Beschichtungsmaterial durch das Zusammenfügen oder Überlappen von einzelnen Linien, nacheinander oder gleichzeitig, beim Aufbringen auf das Fahrzeug oder das Fahrzeugteil erzeugt. Alternativ ist es aber auch denkbar, größere Flächen des Gehäuses mit anderen Methoden aus dem Stand der Technik zu beschichten und nur einzelne Bereiche, beispielsweise Kanten, Rundungen oder komplexe Bereiche, insbesondere solche mit vielen Ausschnitten, gemäß dem erfindungsgemäßen Verfahren mit dem Beschichtungsmaterial zu versehen.

In einer bevorzugten Ausführungsform wird auf das Beschichtungsmaterial ein transparenter Lack und/oder eine transparente Folie aufgebracht wird. Durch den Lack und/oder die Folie wird das Beschichtungsmaterial auf dem Fahrzeugteil vor äußeren Umwelteinflüssen geschützt und gleichzeitig eine Transmission des Sonnenlichtes durch den Lack und/oder die Folie gewährleistet. Insbesondere handelt es sich bei dem transparenten Lack um einen UV-beständigen Lack. Hierdurch wird eine lange Lebensdauer des Lacks erzielt, da die Fahrzeugteile meist der Sonnenstrahlung ausgesetzt sind.

Vorzugsweise wird die Linie und/oder Fläche solaraktiv ausgebildet. Durch eine solaraktive Ausbildung ist es beispielsweise möglich mittels der Fläche Strom zu erzeugen, welcher beispielsweise dann über eine Fahrzeugelektronik verbraucht oder einem Batteriespeicher zugeführt wird.

Eine bevorzugte Ausführungsform zeichnet aus, dass das Beschichtungsmaterial nur bereichsweise zur Erzeugung einzelner Linien oder Flächen auf das Fahrzeug oder Fahrzeugteil aufgebracht wird, wobei zumindest ein Teil der Bereiche, insbesondere alle Bereiche, miteinander elektrisch leitend oder halbleitend verbunden werden. Das Beschichtungsmaterial kann somit nur auf bestimmte Bereiche, beispielsweise ebene Flächen, aufgebracht werden, wodurch insbesondere die Verarbeitung und Herstellung solcher Bereiche erleichtert wird. Durch eine Verbindung der einzelnen Bereiche werden diese miteinander gekoppelt. So dass beispielsweise nur eine elektrische Kontaktierung für den zusammenhängenden Bereich notwendig ist.

Vorzugsweise erfolgt die elektrisch leitende oder halbleitende Verbindung der Flächen über ein Verbindungselement, insbesondere eine Verbindungslinie oder Verbindungsfläche, vorzugsweise aus Beschichtungsmaterial. Damit können Verbindungselemente im gleichen Prozess hergestellt werden wie die Ausbildung der entsprechenden Bereiche mit Beschichtungsmaterial.

Alternativ oder vorzugsweise ergänzend weisen die Punkte und/oder die Linie und/oder die Fläche eine Dicke von bis zu 150 µm auf. Sofern es sich bei den Punkten und/oder die Linien und/oder die Flächen um gewölbte Formen handelt, bezieht sich die vorgenannte Dicke auf die dickste Stelle.

Vorzugsweise weisen die Punkte und/oder die Linie und/oder die Fläche eine Dicke im Bereich von 60 µm bis 120 µm aufweisen. Eine entsprechende Dicke lässt sich schnell und leicht auftragen, wobei gleichzeitig die volle Funktionsfähigkeit des Bereichs aus dem Beschichtungsmaterial gewährleistet wird.

Die Beschichtung erfolgt vorzugsweise in einzelnen Punkten, welche ein Volumen zwischen 0,1 mm³ und 2,0 mm³, bevorzugt zwischen 0,2 mm³ und 1,0 mm³ aufweisen. Die konkrete Punktgröße wird insbesondere durch den Applikator und dessen konkrete Ausgestaltung zur Aufbringung des Beschichtungsmaterials, beispielsweise durch periodisch schleißende Hubelemente im Applikator beeinflusst.

Ein Durchmesser der einzelnen Punkte und/oder die Breite einer Linie aus Beschichtungsmaterial beträgt vorzugsweise bis zu 4 mm, insbesondere in Bereich von 2 mm bis 4 mm.

In einer vorteilhaften Ausführungsform wird das Beschichtungsmaterial in Verfahrensschritt B) in einem Arbeitsgang aufgebracht.

Alternativ oder vorzugsweise ergänzend wird das Beschichtungsmaterial in mehreren Teilschritten in dem Verfahrensschritt B) auf das Fahrzeug oder das Fahrzeugteil aufgebracht. Hierdurch kann das Beschichtungsmaterial auch strukturiert auf das Fahrzeug oder das Fahrzeugteil aufgebracht werden oder ein Schichtverbund aus Beschichtungsmaterial erzeugt werden, wobei der Schichtverbund an Beschichtungsmaterial aus zumindest zwei Schichten besteht. Vorzugsweise handelt es sich bei den Schichten um unterschiedliche Beschichtungsmaterialien, insbesondere um Beschichtungsmaterialien mit unterschiedlichen halbleitenden Materialien. So lassen sich insbesondere elektronische, halbleitende Strukturen und Bauteile erzeugen.

Vorzugsweise handelt es sich bei dem Beschichtungsmaterial um Nanopartikel mit halbleitenden Eigenschaften in einem Dispersionsmedium. Dieses Beschichtungsmaterial lässt sich besonders leicht auf das Fahrzeug oder Fahrzeugteil aufbringen.

In einer bevorzugten Ausführungsform wird das Beschichtungsmaterial nach dem Verfahrensschritt B) ausgehärtet. Durch die Aushärtung wird das Beschichtungsmaterial an seiner Position fixiert und festgelegt, so dass es einer weiteren Verarbeitung zugeführt werden kann ohne seine Form oder Position zu verändern. Insbesondere erfolgt das Aushärten des Beschichtungsmaterials mittels UV-Strahlung und/oder Infrarot-Strahlung. Auch andere Formen der Strahlung sind in Abhängigkeit des gewählten Beschichtungsmaterial geeignet eine entsprechende Aushärtung des Beschichtungsmaterials auszulösen.

Insbesondere umfasst das Beschichtungsmaterial eine unter Strahlung aushärtende Komponente als Härter, welche bevorzugt durch zumindest ein Acrylat, zumindest ein Epoxid oder zumindest ein Enolether gebildet ist. Besonders bevorzugt wird das zumindest eine Acrylat als eine unter Strahlung aushärtende Komponente verwendet.

Es kann bevorzugt sein, dass das Beschichtungsmittel neben der unter Strahlung aushärtenden Komponente ein Lösemittel als weitere Komponente umfasst. Insbesondere ist das Lösemittel auf die unter Strahlung aushärtende Komponente abgestimmt.

In einer weiter bevorzugten Ausführungsform umfasst die unter Strahlung aushärtende Komponente mindestens einen Reaktivverdünner. Der Reaktivverdünner kann zusätzlich zu dem Lösemittel in dem Beschichtungsmaterial umfasst sein oder als Ersatz-Komponente für das Lösemittel dienen. Unter einem Reaktivverdünner versteht man einen Stoff, der die Viskosität eines Beschichtungsmaterials für die Verarbeitung herabsetzt und bei der anschließenden Härtung Teil der auf dem Fahrzeug oder Fahrzeug erzeugten Schicht wird. Die Verbindung erfolgt bei der Aushärtung meist durch Copolymerisation.

Ein übliches Lösemittel nimmt im Gegensatz dazu nicht an chemischen Reaktionen Teil und muss in der Regel nach Abschluss einer Reaktion entfernt werden. Wenn die unter Strahlung aushärtende Komponente ein Acrylat umfasst, so sind als Reaktivverdünner beispielsweise Dipropylenglykoldiacrylat, Tripropylenglykoldiacrylat, Tetrahydrofurfurylacrylat, Isobornylacrylat, Isodecylacrylat, Ethylenethylacrylat, Hexandioldiarcylat, Tricyclodecandimethanoldiacrylat, propoxyliertes Neopentylglykoldiacrylat und propoxylyliertes Trimethylolpropantriacrylat geeignet. Beispielsweise kann das Beschichtungsmaterial eine Kombination aus Isobornylacrylat und Tricyclodecandimethanoldiacrylat umfassen.

In einer weiteren besonders bevorzugten Ausführungsformen umfasst das Beschichtungsmaterial mindestens einen Reaktivverdünner nicht zusätzlich zu dem mindestens einen Acrylat, sondern als das mindestens eine Acrylat. Mit anderen Worten umfasst das Beschichtungsmaterial als vernetzende Komponente dann im Wesentlichen nur einen oder mehrere Reaktivverdünner.

Neben den vorgenannten Bestandteilen kann das Beschichtungsmaterial alternativ oder vorzugsweise ergänzend mindestens ein Additiv, insbesondere einen Photoinitiator, umfassen, beispielsweise ein geeignetes Phosphinoxid.

Alternativ oder vorzugsweise ergänzend kann das Beschichtungsmaterial eine durch Polyaddition oder Polykondensation aushärtende Komponente umfassen. Hierdurch kann eine Aushärtung des Beschichtungsmaterials auch ohne zusätzliche Maßnahmen, wie beispielsweise eine Bestrahlung mittels UV-Licht erfolgen. Alternativ kann zusätzlich das Aushärten durch Wärmeeintrag, beispielsweise mit einer Wärmelampe, und/oder Bestrahlung beschleunigt werden.

Hierzu kann beispielsweise das Beschichtungsmaterial als eine Komponente eine hydroxyfunktionelle Komponente mit einem isocyanatfunktionellen Härter umfassen, also eine zur Herstellung von Polyurethanen verwendbare Komponente. Die hydroxyfunktionelle Komponente ist meist ein Polyol, insbesondere ausgewählt aus der Gruppe mit Polyesterpolyol, Polyetherpolyol, Acrylatpolyol. Der Härter ist beispielsweise m-Tolylidendiisocyanat oder Isophorondiisocyanat.

Alternativ oder vorzugsweise ergänzend handelt es sich bei dem halbleitenden Material zumindest um ein organisches Halbleitermaterial, insbesondere um ein Material aus der Gruppe der konjugierten Moleküle und/oder konjugierten Polymere und/oder der photoaktiven Polymere. Vorzugsweise kann es sich bei dem halbleitenden Material auch um Mischungen aus den vorgenannten Materialien und/oder um Mischungen aus mehreren Materialien einer Gruppe handeln.

Bei den konjugierten Molekülen kann es sich insbesondere um linear kondensierte Ringsysteme, wie beispielsweise Anthracen oder Pentacen, und/oder zweidimensional kondensierte Ringsysteme, wie beispielsweise Hexabenzocoronen, Perylen oder Perylentetracarbonsäuredianhydrid handeln. Weiter kann es sich vorzugsweise bei dem organischen Halbleitermaterial auch um Metallkomplexe, wie beispielsweise Phthalocyanin oder Aluminium-tris(8-hydroxychinolin), und/oder Dendrimere und/oder Starbust-Moleküle und/oder heterozyklische Oligomere, wie beispielsweise Oligothiophene oder Oligophenylenevinylene handeln. Sowohl Metallkomplexe als auch Dendrimere und Oligomere gehören ebenfalls der Gruppe der konjugierten Moleküle an.

Besonders bevorzugt ist jedoch die Verwendung von konjugierten Polymeren, insbesondere von heterozyklische Polymeren und/oder Kohlenwasserstoffketten. Hierbei kommen insbesondere die folgenden Polymere als halbleitendes Material zum Einsatz: Polyethin, Polyanilin, Polyfluoren, Polyparaphenylen, Polyphenylenvinylen, Polypyrrol, Polysulfurnitride oder Polythiophene.

Insbesondere umfasst das Beschichtungsmaterial als halbleitendes Material und somit auch Licht absorbierende Komponente ein konjugiertes Polymer, wobei dem Polymer ein Fulleren-Derivat, insbesondere PCBM, beigemischt wird, um einen schnellen Ladungstransfer zu erzielen.

Bei dem Beschichtungsmaterial kann es sich insbesondere auch um viskose Polymerverbindungen mit kristallinen Additiven handeln.

Das Material kann weitere Beschichtungsmaterial kann neben dem halbleitenden Material auch andere Komponenten beim Austragen und Auftragen umfassen, woraus sich schließlich das halbleitende Material bildet. Insbesondere kann es sich bei dem halbleitenden Material um ein Gemisch aus mehreren Polymeren handeln.

In einer bevorzugten Ausführungsform ist das Beschichtungsmaterial aus einem organischen Material gebildet. Dieses Material lässt sich leicht verarbeiten und hat gute Umwelteigenschaften. Sollte das Beschichtungsmaterial mal abgelöst werden, beispielsweise bei einem Recyclingprozess, so kann diese leicht entsorgt werden.

Alternativ oder vorzugsweise ergänzend ist das Beschichtungsmaterial UV beständig. Da das Fahrzeug oder Fahrzeugteil mit dem Beschichtungsmaterial einer Vielzahl von Umwelteigenschaften, wie beispielsweise der Sonnenstrahlung, ausgesetzt ist, so wird durch ein UV beständiges Beschichtungsmaterial eine lange Lebensdauer des Beschichtungsmaterial erzielt. Zudem wird das Beschichtungsmaterial durch seine UV-Beständigkeit vor Veränderungen durch schädlich UV-Strahlung der Sonne geschützt.

Vorzugsweise wird auf das Fahrzeug oder Fahrzeugteil vor Verfahrensschritt B) ein Haftvermittler aufgebracht. Durch den Haftvermittler wird eine gute Anhaftung des Beschichtungsmaterial auf dem Fahrzeug oder Fahrzeugteil sichergestellt. Vorzugsweise handelt es sich bei dem Haftvermittler um einen Isolator. Durch den Isolator wird eine elektrische Barriere zwischen dem Fahrzeug oder dem Fahrzeugteil und dem Beschichtungsmaterial erzeugt. Insbesondere wird der Haftvermittler als Isolator nur bereichsweise ausgebracht, um beispielsweise einige Stellen zur elektrischen Kontaktierung des halbleitenden Beschichtungsmaterial zu ermöglichen.

In einer bevorzugten Ausführungsform ist das Fahrzeug oder Fahrzeugteil in Verfahrensschritt A) frei von einem Lack. Insbesondere kann das Fahrzeug oder Fahrzeugteil vor Verfahrensschritt B) von einem Lack befreit werden, beispielsweise einem Schutzlack oder ähnlichem.

In einer bevorzugten Ausführungsform handelt es sich bei der Oberfläche um die Außenhaut des Fahrzeugs oder Fahrzeugteils.

Eine vorteilhafte Ausführungsform zeichnet aus, dass auf das Beschichtungsmaterial ein oder mehrere Frontkontakte zur Kontaktierung des Beschichtungsmaterials aufgebracht werden. Somit kann das Beschichtungsmaterial über die Frontkatakte kontaktiert werden. Insbesondere wird der Frontkontakt über ein transparent leitendes Oxid gebildet. Hierdurch wird die solaraktive Fläche des Beschichtungsmaterial nicht reduziert. Vorzugsweise kann der Frontkontakt über ein transparent leitendes Oxid auch gleichzeitig den Lack bilden, so dass keine weitere schützende Schicht auf das Beschichtungsmaterial aufzutragen ist.

Vorzugsweise wird das Beschichtungsmaterial über zumindest einen Rückseitenkontakt kontaktiert, wobei der Rückseitenkontakt bevorzugt durch zumindest einen Kontaktbereich am Fahrzeug oder Fahrzeugteil gebildet wird. Das Fahrzeug oder Fahrzeugteil kann somit selbst den Rückseitenkontakt bilden. Durch den Frontkontakt und den Rückseitenkontakt auf der dem Fahrzeug oder Fahrzeugteil zugewandten Oberfläche der Beschichtung wird ein geschlossener elektrischer Schaltkreis erzeugt.

In einer vorteilhaften Ausführungsform umfasst der Applikator zumindest einen Druckkopf, welcher entlang einer Kontur des Fahrzeugs oder Fahrzeugteils bewegt wird, wobei Druckkopf und Fahrzeug oder Fahrzeugteil relativ zueinander bewegt werden. Hierbei kann der Druckkopf feststehend ausgebildet sein und nur das Fahrzeug oder Fahrzeugteil, beispielsweise auf einer Aufnahme fixiert, relativ zu dem Druckkopf bewegt werden. Alternativ oder vorzugsweise ergänzend kann der Druckkopf auch bewegt werden, wobei das Fahrzeug oder Fahrzeugteil ortsfest verbleibt. Hierdurch wird insbesondere eine bessere Flexibilität beim Aufbringen des Beschichtungsmaterials erreicht. Der Applikator lässt sich meist leichter bewegen als ein ganzes Fahrzeug oder ein größeres Fahrzeugteil, wobei auch die Anpassung der Bewegung an die Kontur des Fahrzeuges oder Fahrzeugteils bei einem beweglichen Applikator leichter ist.

Alternativ oder vorzugsweise ergänzend weist der Applikator mehrere Druccköpfe aus, wodurch der Prozess des Aufbringens des Beschichtungsmaterials beschleunigt wird. Insbesondere können die einzelnen Druckköpfe am Applikator einzeln angesteuert werden, so dass neben dem Austrag an dem Beschichtungsmaterial auch die Lage der Druckköpfe relativ zueinander und/oder in ihrer Anordnung zum Fahrzeug oder Fahrzeugteil unabhängig verstellt und eingestellt werden.

Eine bevorzugte Ausführungsform zeichnet aus, dass das Fahrzeug oder das Fahrzeugteil, insbesondere eine Oberfläche des Fahrzeugs oder Fahrzeugteil aus einem der folgenden Materialien aufgebaut ist: Aluminium oder Aluminium-Legierung, Eisen oder Eisen-Legierung, Stahl, insbesondere verzinkter Stahl oder Edelstahl, Glas oder faserverstärkter Kunststoff, insbesondere Carbon-faserverstärkter Kunststoff.

Weitere vorteilhafte Ausgestaltungsformen der Erfindung ergeben sich auch aus der folgenden Darstellung von Ausführungsformen der Erfindung in Bezug auf die Figuren. Es zeigen:
- Figur 1: einen schematischen Aufbau der Beschichtung auf einem Fahrzeugteil in einer Schnittansicht;
- Figur 2: einen schematischen Aufbau der Beschichtung auf einem Fahrzeugteil in einer Schnittansicht gemäß einer weiteren Ausführungsform; und
- Figur 3: eine Draufsicht auf ein Fahrzeugteil mit einer Beschichtung;
- Figur 4: eine schematische Darstellung eines Ausschnitts aus einer Fläche mit Beschichtungsmaterial.

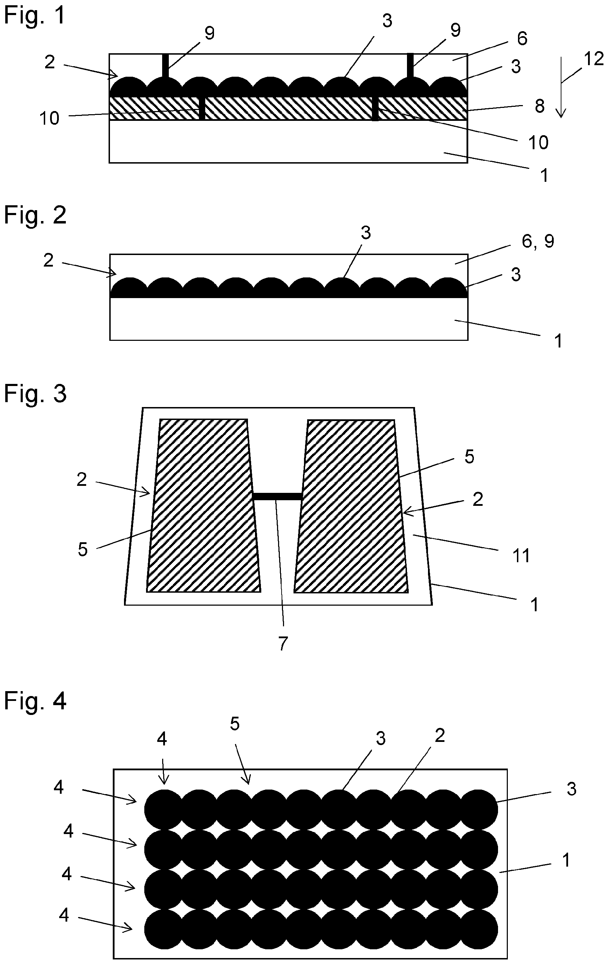

In Figur 1 ist in einer schematischen Schnittansicht ein mit einem Beschichtungsmaterial 2 versehenes Fahrzeugteil 1 dargestellt. Bei dem Fahrzeugteil 1 handelt es sich beispielsweise um eine Motorhaube eines Kraftfahrzeuges. Es kann sich bei dem Fahrzeugteil 1 aber auch um Holme, Türen, Kofferraumabdeckungen, Seitenteile oder ein Dach eines Kraftfahrzeuges handeln.

Das Fahrzeugteil 1 wird zunächst bereitgestellt und liegt hierbei in einem Verarbeitungszustand vor. Insbesondere ist das Fahrzeugteil 1 gereinigt und frei von weiteren zusätzlichen Stoffen auf seiner Oberfläche 11, insbesondere frei von einem Schutzlack. Bei dem Fahrzeugteil 1 selbst besteht aus einem verzinkten Stahl. Alternativ kann das Fahrzeugteil 1 auch aus Aluminium oder Aluminium-Legierung oder Eisen oder Eisen-Legierung gefertigt sein. Denkbar ist auch die Verwendung von Glas oder eines faserverstärkten Kunststoffs, insbesondere einer Carbon-faserverstärkter Kunststoffs, als Material für das Fahrzeugteil 1.

Vor dem Aufbringen eines Beschichtungsmaterials 2 auf das Fahrzeugteil 1 wird zunächst ein Haftvermittler flächig auf das Fahrzeugteil 1 aufgetragen. Bei dem Haftvermittler kann es sich insbesondere um einen Acryl-Haftvermittler oder auch um Octadecyltrichlorsilan (OTS) oder Hexamethyldisilazan (HMDS) handeln. Durch den Haftvermittler 8 wird eine gute Verbindung zwischen dem Fahrzeugteil 1 und dem Beschichtungsmaterial 2 erzielt. Zudem ist der Haftvermittler aus einem elektrisch isolierenden Material gebildet, um eine elektrische Barriere zwischen dem halbleitenden Beschichtungsmaterial 2 und dem Fahrzeugteil 1 zu erzielen.

Um dennoch eine elektrische Kontaktierung des Beschichtungsmaterials 2 zu erzielen, sind in dem Haftvermittler 8 Rückseitenkontakte 10 ausgebildet, welche eine elektrische Kontaktierung des Beschichtungsmaterials 2 über das Fahrzeugteil 1 zu ermöglichen. Die Rückseitenkontakte 10 können beispielsweise aus Silber oder Gold gebildet sein, wodurch eine gute Kontaktierung des halbleitenden Beschichtungsmaterial 2 gegeben ist.

Auf dem Haftvermittler 8 ist das Beschichtungsmaterial 2 unmittelbar mittels eines Applikators aufgebracht. Mittels eines Applikators wurden einzelne Punkte 3 an Beschichtungsmaterial 2 aufgebracht, wobei die Anordnung der einzelnen Punkte 3 so erfolgte, dass diese sich zumindest in einem Bereich überlappen und eine zusammenhängen Bereich an Beschichtungsmaterial 2 ausbilden.

Bei dem Beschichtungsmaterial 2 in Form eines halbleitenden Materials handelt es sich vorliegenden um einen organischen Halbleiter, insbesondere um ein halbleitendes Material aus der Gruppe konjugierten Moleküle oder konjugierten Polymere. Vorliegend umfasst das Beschichtungsmaterial 2 Polypyrrol als halbleitendes Material. Alternativ kann über den Applikator auch ein Halbleiter wie Silizium oder Germanium aufgebracht werden, wobei die technischen Anforderungen hinsichtlich des Ausbringen für diese Art an halbleitendem Material deutlich höher sind. Daher ist die Verwendung von organischen Halbleitern als Beschichtungsmaterial 2 bevorzugt.

Das Beschichtungsmaterial 2 kann neben dem organischen Halbleiter weiter Komponenten umfassen wie beispielsweise einen Härter, ein Lösemittel oder ein Reaktivverdünner. Hierdurch lassen sich unter anderem die Viskosität des Beschichtungsmaterials 2 beim Aufbringen auf das Fahrzeugteil 1 verbessern und gleichzeitig ein Verfließen der einzelnen Punkte 3 an Beschichtungsmaterial nach dem Auftragen verhindern. Vorliegend umfasst das Beschichtungsmaterial als eine weitere Komponente einen Härter in Form eines Acrylats, welcher durch Bestrahlung mittels UV-Licht aushärtet. Durch die Bestrahlung erfolgt rasch eine Aushärtung des Materials, so dass das Fahrzeugteil im Anschluss schnell weiterverarbeitet werden kann.

Die einzelnen Punkte 3 an Beschichtungsmaterial 2 haben eine Breite von 1 mm und weisen eine Dicke in Dickenrichtung 12 von 60 µm auf. Die Dicke von 60 µm bezieht sich hierbei auf die dickste Stelle des einzelnen Punktes 3.

Wie in Figur 1 dargestellt, wurde nach dem Auftragen des Beschichtungsmaterials 2 auf dieses eine weitere Schicht in Form eines transparenten Lacks 6 aufgebracht. Durch den Lack 6 wird das Beschichtungsmaterial 2 vor äußeren Umwelteinflüssen wie Feuchtigkeit oder Strahlung geschützt. Bei dem lack 6 handelt es sich um einen UV-beständigen Lack, da das Fahrzeugteil 1 auch der Sonnenstrahlung ausgesetzt ist, wodurch ein gewöhnlicher Lack Schaden nehmen und degenerieren kann. Alternativ zu einem Lack 6 kann ein Schutzfilm auf dem Beschichtungsmaterial 2 auch durch eine Folie gebildet werden.

Um das Beschichtungsmaterial 2 auch von der Vorderseite kontaktieren zu können, sind in dem transparenten Lack 6 Frontkontakte 9 ausgebildet. Die frontkontakte 9 stehen an einigen Stellen in Kontakt mit dem Beschichtungsmaterial und können über Leitungen (nicht dargestellt) miteinander verbunden sein. Wie die Rückseitenkontakte 10 können auch die Frontkontakte 9 aus Gold oder Silber gebildet sein.

In Figur 2 ist eine weitere Ausführungsform eines mit einem halbleitenden Material beschichteten Fahrzeugteils 1 dargestellt, welche sich in einigen Aspekten von der Ausführungsform in Figur 1 unterscheidet. Das Beschichtungsmaterial 2, wiederum vorliegend als einzelne Punkte 3 aus einem organischen Halbleiter, sind nun direkt auf das Fahrzeugteil 1 unmittelbar auf dessen Oberfläche 11 aufgebracht. Für eine verbesserte Haftung er einzelnen Punkte 3 auf dem Fahrzeugteil kann das Beschichtungsmaterial 2 als eine Komponente auch einen Haftvermittler umfassen.

Die einzelnen Punkte 3 an Beschichtungsmaterial 2 überlappen wiederum gegenseitig und bilden somit eine Linie an Beschichtungsmaterial 2 aus. Durch das Fahrzeugteil 1 selbst erfolgt eine Kontaktierung des halbleitenden Material in dem Beschichtungsmaterial 2. An der dem Fahrzeugteil 1 abgewandten Seite ist auf dem Beschichtungsmaterial 2 wiederum eine Schutzschicht in Form eines transparent leitenden Oxids aufgebracht. Das transparent leitende Oxid dient einerseits als Frontkontakt 9 und gleichzeitig als Lack 6, wodurch das Beschichtungsmaterial 2 vor Umwelteinflüssen geschützt ist. Alternativ kann auf dem Frontkontakt in Form eines transparent leitenden Oxids auch noch eine weitere Schutzschicht in Form eines Lackes 6 aufgebracht sein.

In Figur 3 ist stilisiert ein Fahrzeugteil 1, vorliegend eine Motorhaube, dargestellt. Auf der Oberfläche 11 des Fahrzeugteils 1 sind zwei Flächen 5 ausgebildet, auf welchen das Beschichtungsmaterial 2 aufgebracht wurde. Die Flächen 5 werden, wie dies schematisch und ausschnittsweise in Figur 4 gezeigt ist, durch Ausbringen einer Vielzahl von einzelnen, sich überlappenden Punkten 3 an Beschichtungsmaterial 2 ausgebildet, wobei die einzelnen Punkte zunächst in Linien 4 ausgebracht und auf dem Fahrzeugteil 1 ausgebildet werden. Die Ausbildung der Linien 4 kann hierbei in der Bildebene zunächst erst horizontal erfolgen, wobei im Anschluss eine weitere Linie 4 vertikal versetzt zu der ersten Linie ausgebildet wird. Alternativ können die Linien 4 durch Ausbilden der einzelnen Punkte 3 in der Bildebene vertikal untereinander erzeugt werden, wobei eine weitere Linie 4 benachbart hierzu im Anschluss ausgebildet wird. Alternativ können die Linien 4 durch Ausbilden der einzelnen Punkte 3 in der Bildebene kreisförmig angeordnet werden, wobei eine weitere Linie 4 benachbart hierzu bevorzugt versetzt kreisförmig ausgebildet wird (nicht dargestellt). Alternativ können die Linie 4 durch Ausbilden der einzelnen Punkte 3 in der Bildebene mittels beliebiger geometrischer Linien beispielsweise in Wellenform angeordnet werden, wobei eine weitere Linie 4 benachbart hierzu bevorzugt versetzt in derselben geometrischen Anordnung ausgebildet wird (nicht dargestellt).

Die einzelnen Punkte weisen vorliegend einen Durchmesser von bis zu 4 mm auf, wobei ein Punkt von einem Druckkopf ausgebildet wird. Entsprechend weist auch eine aus mehreren Punkten ausgebildete Linie eine Breite entsprechend des Durchmessers der Punkte von bis zu 4 mm auf.

Auch können mehrere Linien 4 gleichzeitig ausgebildet werden. Hierzu umfasst der Applikator entweder mehrere Druckköpfe, welche das Ausbilden der einzelnen Punkte in einem bestimmten Abstand zueinander ermöglichen, oder es werden mehrere Applikatoren mit jeweils einem oder mehreren Druckköpfen verwendet, wobei je Applikator eine oder mehrere Linien ausgebildet werden können.

Die einzelnen Flächen 5 sind, wie in Figur 3 gezeigt, über ein Verbindungselement 7 miteinander elektrisch leitend verbunden. Bei dem Verbindungselement 5 kann es sich um ein Metall handeln. Vorliegend wird als Verbindungselement 7 auch das Beschichtungsmaterial 2 verwendet, so dass die beiden Flächen 5 sowie das Verbindungselement 7 materialeinheitlich ausgebildet sind. Hierdurch können sowohl die Flächen 5 als auch das Verbindungselement 7 in einem Arbeitsgang mit dem Applikator ausgebildet werden.

### Bezugszeichenliste

- 1: Fahrzeugteil
- 2: Beschichtungsmaterial
- 3: Punkt
- 4: Linie
- 5: Fläche
- 6: Lack
- 7: Verbindungselement
- 8: Haftvermittler
- 9: Frontkontakt
- 10: Rückseitenkontakt
- 11: Oberfläche des Fahrzeugteils
- 12: Dickenrichtung

## Patentansprüche

1. Verfahren zum Aufbringen einer Beschichtung auf ein Fahrzeug, insbesondere ein Automobil, oder ein Fahrzeugteil (1), mit den Verfahrensschritten:
A) Bereitstellen eines Fahrzeugs oder Fahrzeugteils (1);
B) Aufbringen eines flüssigen Beschichtungsmaterials (1) auf eine Oberfläche (11) des Fahrzeuges oder des Fahrzeugteils (1) mittels eines Applikators, wobei das Beschichtungsmaterial (2) in einzelnen Punkten (3) auf die Oberfläche (11) aufgebracht wird, wobei die Punkte (3) aneinandergrenzend oder überlappend zueinander auf der Oberfläche (11) angeordnet werden, so dass diese eine zusammenhängende Linie (4) oder Fläche (5) ausbilden,
**dadurch gekennzeichnet, dass** als Beschichtungsmaterial (2) zumindest ein halbleitendes Material verwendet wird oder umfasst.

2. Verfahren nach einem der vorhergehenden Ansprüche, **dadurch gekennzeichnet, dass** auf das Beschichtungsmaterial (2) ein transparenter Lack (6), insbesondere ein UV beständiger Lack, und/oder eine transparente Folie aufgebracht wird.

3. Verfahren nach einem der vorhergehenden Ansprüche, **dadurch gekennzeichnet, dass** die Linie (4) oder Fläche (5) solaraktiv ausgebildet wird oder ist.

4. Verfahren nach einem der vorhergehenden Ansprüche, **dadurch gekennzeichnet, dass** das Beschichtungsmaterial (2) nur bereichsweise zur Erzeugung einzelner Linien (4) und/oder Flächen (5) aufgebracht wird, wobei zumindest ein Teil der Bereiche, insbesondere alle Bereiche, miteinander elektrisch leitend verbunden werden oder sind, vorzugsweise über ein Verbindungselement (7), insbesondere eine Verbindungslinie oder Verbindungsfläche, vorzugsweise aus dem Beschichtungsmaterial (2).

5. Verfahren nach einem der vorhergehenden Ansprüche, **dadurch gekennzeichnet, dass** die Punkte (3) und/oder die Linie (4) und/oder die Fläche (5) eine Dicke von bis zu 150 µm aufweisen, vorzugsweise dass die Punkte (3) und/oder die Linie (4) und/oder die Fläche (5) eine Dicke im Bereich von 60 µm bis 120 µm aufweisen.

6. Verfahren nach einem der vorhergehenden Ansprüche, **dadurch gekennzeichnet, dass** das Beschichtungsmaterial (2) nach dem Verfahrensschritt B) ausgehärtet wird, insbesondere mittels UV-Strahlung und/oder Infrarot-Strahlung.

7. Verfahren nach einem der vorhergehenden Ansprüche, **dadurch gekennzeichnet, dass** es sich bei dem halbleitenden Material zumindest um ein organisches Halbleitermaterial handelt, insbesondere um ein Material aus der Gruppe der konjugierten Moleküle und/oder konjugierten Polymere.

8. Verfahren nach einem der vorhergehenden Ansprüche, **dadurch gekennzeichnet, dass** das Beschichtungsmaterial (2) aus einem organischen Material gebildet ist und/oder dass das Beschichtungsmaterial (2) UV beständig ist.

9. Verfahren nach einem der vorhergehenden Ansprüche, **dadurch gekennzeichnet, dass** auf das Fahrzeug oder Fahrzeugteil (1) vor Verfahrensschritt B) ein Haftvermittler (8) aufgebracht wird, wobei es sich bei dem Haftvermittler (8) vorzugsweise um einen Isolator handelt.

10. Verfahren nach einem der vorhergehenden Ansprüche, **dadurch gekennzeichnet, dass** das Fahrzeug oder Fahrzeugteil (1) in Verfahrensschritt A) frei von einem Schutzlack ist.

11. Verfahren nach einem der vorhergehenden Ansprüche, **dadurch gekennzeichnet, dass** es sich bei der Oberfläche (11) um die Außenhaut des Fahrzeugs oder Fahrzeugteils (1) handelt.

12. Verfahren nach einem der vorhergehenden Ansprüche, **dadurch gekennzeichnet, dass** auf das Beschichtungsmaterial (2) ein oder mehrere Frontkontakte (9) zur Kontaktierung des Beschichtungsmaterials (2) aufgebracht werden, insbesondere dass der Frontkontakt (9) durch ein transparent leitendes Oxid gebildet wird.

13. Verfahren nach einem der vorhergehenden Ansprüche, **dadurch gekennzeichnet, dass** das Beschichtungsmaterial (2) über zumindest einen Rückseitenkontakt (10) kontaktiert wird, wobei der Rückseitenkontakt (10) vorzugsweise durch zumindest einen Kontaktbereich am Fahrzeug oder Fahrzeugteil (1) gebildet wird.

14. Verfahren nach einem der vorhergehenden Ansprüche, **dadurch gekennzeichnet, dass** der Applikator zumindest einen Druckkopf umfasst, welcher über eine Kontur des Fahrzeugs oder Fahrzeugteils (1) bewegt wird, wobei Druckkopf und Fahrzeug oder Fahrzeugteil (1) relativ zueinander bewegt werden.

15. Verfahren nach einem der vorhergehenden Ansprüche, **dadurch gekennzeichnet, dass** das Fahrzeug oder das Fahrzeugteil (1), insbesondere eine Oberfläche (11) des Fahrzeugs oder Fahrzeugteil (1) aus einem der folgenden Materialien aufgebaut ist: Aluminium oder Aluminium-Legierung, Eisen oder Eisen-Legierung, Stahl, insbesondere verzinkter Stahl oder Edelstahl, Glas oder faserverstärkter Kunststoff, insbesondere Carbon-faserverstärkter Kunststoff.
